# EUROPEAN PATENT APPLICATION

(11) **EP 0 751 700 A2**
(43) Date of publication of application: **02.01.1997**
(21) Application number: 96110226.6
(22) Date of filing: 25.06.1996
(51) Int. Cl.: H05K 3/00, H03K 3/00, B32B 9/00, B32B 15/08

(54) **Copper-clad laminate, process for producing the same, printed wiring board, and process for producing the same**

(30) Priority: 30.06.1995 JP 165131/95
(71) Applicant: HITACHI, LTD., Chiyoda-ku, Tokyo 101 (JP)
(72) Inventor: Yamaguchi, Motoo, Hitachi-shi (JP)
(74) Representative: Beetz & Partner Patentanwälte

(57) **Abstract**

The object of the present invention is to provide a copper-clad laminate (12) in which the direct contact between roughened surface of conductor (4a-d) and glass fiber base (1) is prevented and the lifetime of insulation can be guaranteed over a long period of time without loosing the electrical insulaing performance between conductive lines (4a-d), even if the pitch between conductive lines in signal copper wire is small. For achieving the object, the present invention is characterized by having a prepreg (3) obtained by impregnating a glass fiber base (1) with epoxy, polyimide or bismaleimide resin (2), a copper foil (4) stuck onto one surface or both surfaces of the prepreg (3), and an insulating layer (5) containing no glass fiber base (1) between the prepreg (3) and copper foil (4).

## Description

The present invention relates to a copper-clad laminate, a process for producing the copper-clad laminate, a printed wiring board, and a process for producing the printed wiring board. In particular, the present invention relates to a copper-clad laminate for use in devices requiring a fine pitch pattern for high-density wiring such as personal computer, portable telephone, video camera and the like, a process for producing the copper-clad laminate, a printed wiring board, and a process for producing the printed wiring board.

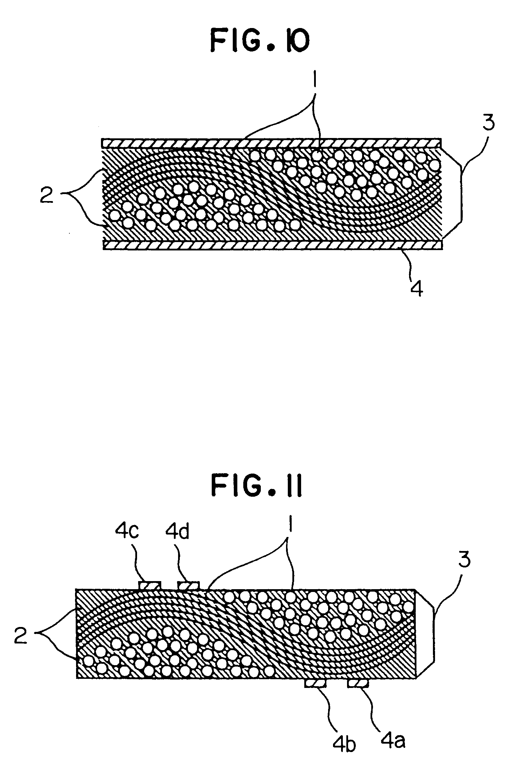

Fig. 10 illustrates the cross-sectional structure of the copper-clad laminate disclosed in JP-A-2-187332, as one example of prior copper-clad laminates.

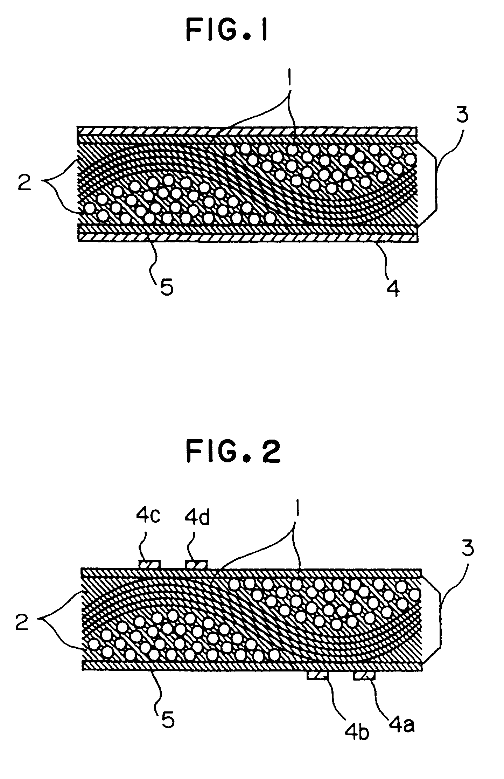

As shown in Fig. 1, a copper-clad laminate is formed by providing a prepreg 3 constituted of glass fiber 1 forming a glass cloth substrate and an insulating material, and a copper foil 4 stuck onto both surfaces of the prepreg 3, and heating these materials.

As a method for improving the flatness of copper foil 4, JP-A-2-187332 mentions a method of coating copper foil 4 with resin 2, curing the resin 2, impregnating a glass cloth substrate with a thermosetting resin to prepare a prepreg 3, laminating the prepreg with the coated copper foil, and then curing the laminate.

In the prior copper-clad laminate mentioned above, however, the glass fiber can be brought into contact with the boundary face of copper foil 4 in some occasions. In a state that glass fiber 1 is in contact with the boundary face of copper foil 4, the pitch of signal copper wire becomes small and, when the space between conductive lines formed by etching the copper foil of copper-clad laminate is smaller than 0.1 mm, there arises a state that two conductors stand side-by-side in the vicinity of glass fiber 1 in the surface layer of prepreg 3, as represented by conductors 4a and 4b or by 4c and 4d of Fig. 11.

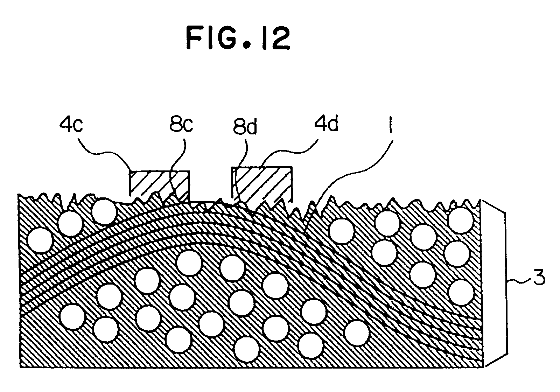

Fig. 12 is a magnified view of the boundary face between the conductive lines 4c, 4d discrete at very short space and prepreg 3. As is apparent from Fig. 12, the roughened surfaces 8c and 8d of the conductors 4c and 4d come into contact with glass fiber 1 in the surface layer of prepreg 3.

In such a state, the copper of the conductors 4c and 4d dissolves out along the glass fiber 1, which causes a short-circuit between conductive lines 4c and 4d. As its result, the electric insulation between conductive lines 4c and 4d is lost, and conductive lines 4c and 4d become unusable for sending exact signals.

When the space of conductive lines 4c, 4d is wide, any of conductive line 4c and conductive line 4d is in no contact with glass fiber 1 even if glass fiber has occasion to contact with the boundary face of copper foil 4. In the prior art, therefore, the above-mentioned phenomenon has not taken place, and it has been unnecessary at all to take such a phenomenon into consideration. However, as a result of miniaturization of daily goods such as personal computer, portable telephone, video camera and the like, the space between conductive lines has become short than 0.1 mm in some uses, and the above-mentioned problem has arisen.

The present invention has been worked out in view of the above-mentioned problem, and the object of the present invention consists in providing a copper-clad laminate in which the direct contact of the roughened surface of conductor with the glass fiber base is prevented and the electrical insulating performance between conductors is maintained for a long period of time even if the conductive line pitch in signal copper wire is short so that a long insulating lifetime can be guaranteed, a process for producing such a copper-clad laminate, a printed wiring board, and a process for producing such a printed wiring board.

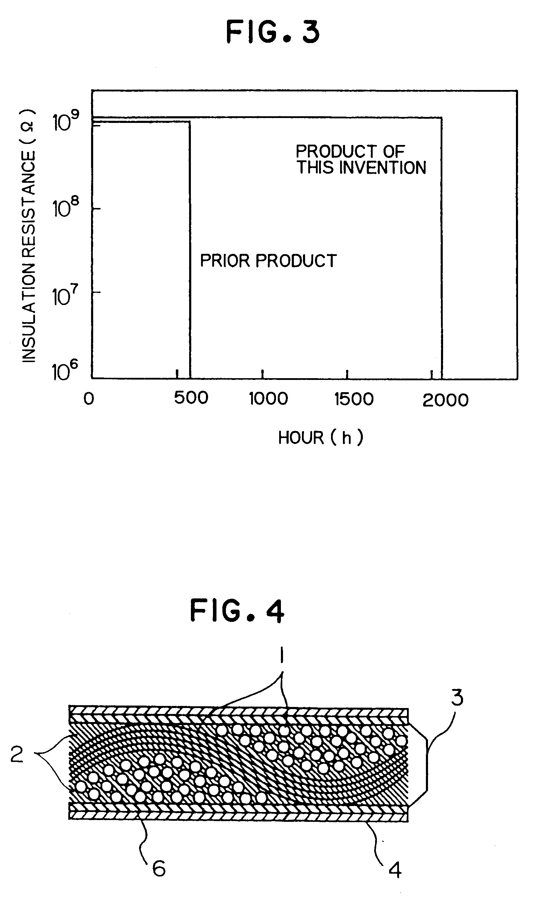

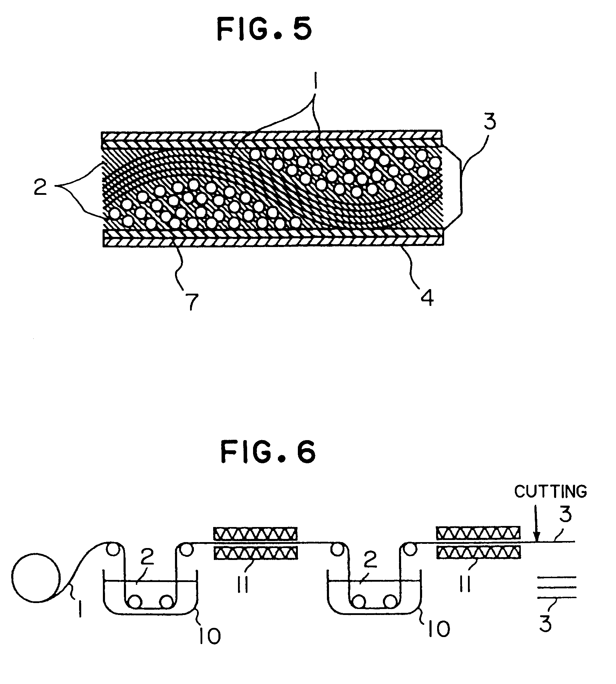

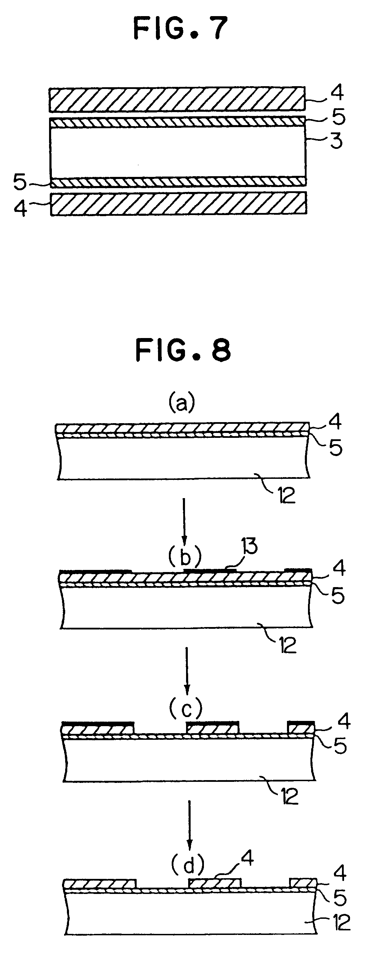

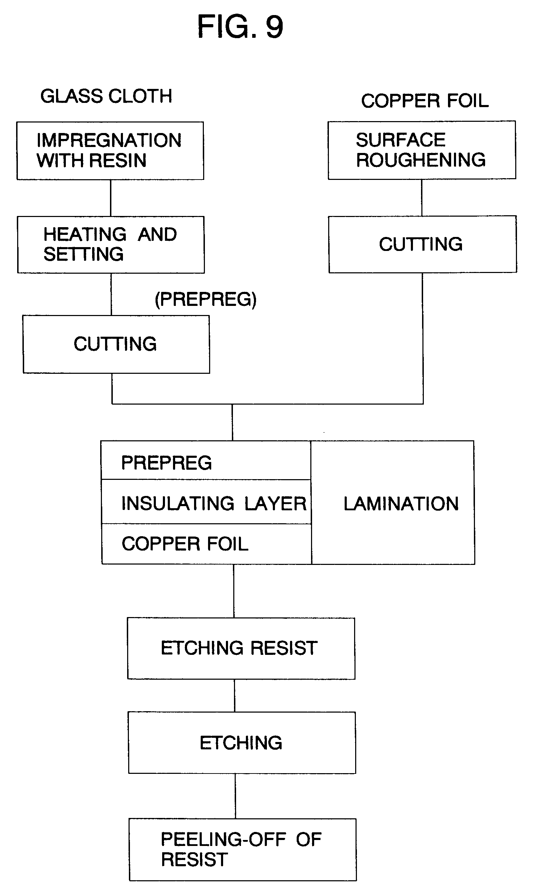

Fig. 1 is a cross-sectional view illustrating one example of the copper-clad laminate of the present invention; Fig. 2 is a cross-sectional view illustrating an example of the printed wiring board prepared by processing the copper-clad laminate of the present invention; Fig. 3 is a graph in which the insulation-deteriorating performance of the copper-clad laminate of the present invention is compared with the insulation-deterioration performance of prior copper-clad laminate; Fig. 4 is a cross-sectional view illustrating another example of the copper-clad laminate of the present invention; Fig. 5 is a cross-sectional view illustrating a yet another example of the copper-clad laminate of the present invention; Fig. 6 is a diagram illustrating the process for producing the prepreg used in the present invention; Fig. 7 is a cross-sectional view illustrating the process for producing the copper-clad laminate of the present invention from the prepreg produced according to Fig. 6; Fig. 8 is a diagram illustrating the process for producing a printed wiring board from the copper-clad laminate; Fig. 9 is a diagram illustrating the process for producing a copper-clad laminate of the present invention and the process for producing a printed wiring board from the copper-clad laminate; Fig. 10 is a cross-sectional view illustrating prior copper-clad laminate; Fig. 11 is a cross-sectional view illustrating an example of prior copper-clad laminate after being processed; and Fig. 12 is a magnified cross-sectional view of prior copper-clad laminate after being processed; wherein:
1 --- glass fiber, 2 --- resin, 3 --- prepreg, 4 --- copper foil, 4a, 4b, 4c --- conductive lines, 5 --- semi-cured resin, 6 --- semi-cured resin film, 7 --- adhesive, 8c, 8d --- roughened surfaces of conductors, 10 --- varnish tank, 11 --- hot air type horizontal impregnation-drying apparatus, 12 --- copper-clad laminate, 13 --- etching resist.

The present invention is characterized by having the following aspects:
In a copper-clad laminate formed by impregnating a glass fiber base with epoxy resin, polyimide resin or bismaleimide resin to obtain a prepreg, sticking a copper foil onto one surface or both surfaces of the prepreg, and then subjecting said prepreg and said copper foil to a heat press under an elevated pressure,
the copper-clad laminate characterized by providing an insulating layer containing no glass fiber base between said prepreg and said copper foil;
In a process for producing a copper-clad laminate formed by impregnating a glass fiber base with epoxy resin, polyimide resin or bismaleimide resin to obtain a prepreg, sticking a copper foil onto one surface or both surfaces of the prepreg, and then subjecting said prepreg and said copper foil to a heat press under a high pressure,
the process for producing a copper-clad laminate characterized by providing an insulating layer on one surface or both surfaces of said prepreg, sticking a copper foil onto the surface of said insulating layer, and thereafter carrying out a heat press under a high pressure;
In a printed wiring board obtained by preparing a copper-clad laminate by impregnating a glass fiber base with epoxy resin, polyimide resin or bismaleimide resin to form a prepreg, sticking a copper foil onto one surface or both surfaces of the prepreg, carrying out a heat press under a high pressure and then etching the copper foil of the copper-clad laminate so as to form a pattern having 0.1 mm or less space of conductive line,
the printed wiring board characterized by providing an insulating layer containing no glass fiber base between the prepreg and the copper foil;
In a process for producing a printed wiring board by impregnating a glass fiber base with epoxy resin, polyimide resin or bismaleimide resin to form a prepreg, sticking a copper foil onto one surface or both surfaces of the prepreg, carrying out a heat press under a high pressure to form a copper-clad laminate and etching the copper foil on the copper-clad laminate so as to form a pattern having 0.1 mm or less space of conductive line,
the process for producing a printed wiring board characterized by using a copper-clad laminate obtained by providing an insulating layer containing no glass fiber base on one surface or both surfaces of the prepreg, sticking a copper foil onto the surface of the insulating layer and thereafter carrying out a heat press under a high pressure.

Concrete means of the above-mentioned insulating layer include a material obtained by coating the surface of a prepreg with a resin and bringing the resin into a semi-cured state, a semi-cured resin film inserted between a prepreg and a copper foil, and a prepreg of which surface is coated with an insulating binding agent.

In a copper-clad laminate, adhesive surface is roughened by making the surface irregular, in order to bonding and fixing the copper foil to a glass fiber-reinforced resin insulating material. If the roughened surface comes into contact with the glass fiber base, the copper is dissolved out or again deposited along the substrate, as a result of which the wiring conductors prepared by etching or the like are brought into a state of continuity and the electrical independence of wiring conductors is lost.

The contact between roughened surface of conductor and substrate can be prevented by providing an insulating layer containing no glass fiber base between the prepreg prepared by impregnating a glass fiber base with epoxy resin, polyimide resin or bismaleimide resin and the copper foil stuck onto one surface or both surfaces of the prepreg, as in the copper-clad laminate of the present invention.

As its result, the dissolution of copper along the substrate can be prevented, and the insulation lifetime of copper-clad laminate against deterioration can be prolonged.

Hereunder, the present invention is explained on the basis of the drawings illustrating the examples.

Fig. 1 illustrates one example of the copper-clad laminate of the present invention. As shown in Fig. 1, the copper-clad laminate of the present invention has a prepreg 3 obtained by impregnating a glass fiber base 1 with resin 2 constituted of epoxy resin, polyimide resin or bismaleimide resin, a copper foil 4 stuck onto one surface or both surfaces of the prepreg 3, and an insulating layer provided between the prepreg 3 and the copper foil 4, wherein said insulating layer contains no glass fiber base (in the case of Fig. 1, the insulating layer is semi-cured resin 5). Such a laminate is formed by placing an insulating layer (semi-cured resin 5) on one surface or both surfaces of prepreg 3, sticking copper foil 4 onto the surface of the insulating layer, and thereafter carrying out a heat press under a high pressure.

Next, the process for producing the above-mentioned copper-clad laminate is explained with reference to Fig. 6. As shown in Fig. 6, glass fiber 1 constituted of 400 monofilaments, each monofilament having a diameter of 9 µm, is woven into the form of a cloth to give a substrate, the substrate is impregnated in varnish tank 10 containing resin 2 constituted of epoxy, polyimide or bismaleimide resin, and the impregnated substrate is passed through a hot air type horizontal impregnation-drying apparatus 11 to form a prepreg. The prepreg thus obtained is again passed through varnish tank 10 containing the same resin 2 constituted of epoxy, polyimide or bismaleimide resin as used above for impregnation and hot air type horizontal impregnation-drying apparatus 11 to form an insulating layer of semi-cured resin 5 of which one side thickness is about 50 µm, and then the whole is cut into about 1 m squares.

In the above-mentioned manner, a layer of semi-cured resin 5 can be provided on the surface of the substrate-containing prepreg 3, as shown in Fig. 7. Then, copper foil 4 having a thickness of 18 µm, of which bonding side surface has been roughened, is stuck onto the surface of the semi-cured resin 5 and then the whole is formed under elevated pressure by means of heat press to obtain a copper-clad laminate.

Then, on the copper-clad laminate obtained above, the copper foil part 4 is etched so as to give conductive line space of 80 µm as shown in Fig. 2, in the areas where the glass fiber base 1 is close to the surface of prepreg 3. Thus, a printed wiring board is obtained.

This production process of printed wiring board is explained by referring to the process scheme of Fig. 8. Fig. 8 (a) illustrates copper-clad laminate 12 prepared in the above-mentioned manner. Then, as shown in Fig. 8 (b), etching resist 13 is applied onto copper foil 4 so as to form a prescribed pattern. By carrying out an etching treatment in this state, the copper foil 4 onto which no etching resist is applied is etched off as shown in Fig. 8 (c). Finally, the etching resist 13 is peeled off, whereby a printed wiring board on which the prescribed conductor pattern is formed can be obtained.

Fig. 9 illustrates the process for producing a copper-clad laminate and the process for producing a printed wiring board from the copper-clad laminate, both explained in this example. Explanation of Fig. 9 is omitted here, because it has already been presented above.

Next, an insulation deterioration test is carried out on the printed wiring board produced above, in order to ascertain the effect of the present invention.

The test is carried out at a temperature of 85°C, at a humidity of 85%RH, and at an aging voltage of 100 V. The period of time required for decreasing the insulating resistance to 10⁶ Ω is taken as lifetime.

For comparison, a sample of prior process is also used. This comparative sample is prepared by the general process mentioned below. Thus, glass fiber 1 constituted of 400 monofilaments, each monofilament having a diameter of 9 µm, is woven into the form of a cloth to prepare a substrate. The substrate is impregnated with epoxy resin in a varnish tank, passed through a hot air type horizontal impregnation-drying apparatus to form prepreg 3, and the prepreg is cut into about 1 m squares.

From the samples prepared in the above-mentioned manner, a sample in which glass fiber 1 is located near the surface of prepreg 3 is selected. Then, the copper foil part 4 is etched so as to give conductive line space of 80 µm to obtain a sample in which roughened surface 8c, 8d of conductive lines 4c, 4d are in contact with glass fiber 1, as shown in Fig. 12. Fig. 3 illustrates a result of accelerated deterioration test of this sample compared with that of a sample obtained by prior process. That is, the sample obtained by prior process reaches lifetime (10⁶ Ω) when 500 odd hours has passed, while the sample of the present invention reaches 10⁶ Ω when more than 2,000 hours has passed, demonstrating that lifetime is prolonged about 4 times.

Fig. 4 illustrates a sample in which a semi-cured resin film 6 formed elsewhere is used in place of the semi-cured resin 5 formed on the surface of prepreg 3 of Fig. 1. Fig. 5 illustrates a sample in which a binding agent 7 is used in place of the semi-cured resin 5 formed on the surface of prepreg 3 of Fig. 1. In both samples, an accelerated deterioration test gives just the same result as in Fig. 3.

As has been mentioned above, the copper-clad laminate of the present invention is obtained by impregnating a glass fiber base with epoxy resin, polyimide resin or bismaleimide resin to give a prepreg, sticking a copper foil onto one surface or both surfaces of the prepreg, and providing an insulating layer containing no glass fiber base between the prepreg and the copper foil. Accordingly, the copper-clad laminate, the process for producing said copper-clad laminate, the printed wiring board and the process for producing said printed wiring board of the present invention exhibit an excellent effect that the contact between the roughened surface of conductor and the substrate can be prevented and therefore the dissolution of copper along substrate can be prevented, and the lifetime of insulation can be guaranteed for a long period of time without losing the electrical insulating performance between conductive lines even if the pitch between conductive lines of signal copper wire is short.

## Claims

1. In a copper-clad laminate formed by impregnating a glass fiber base (1) with epoxy resin, polyimide resin (2) or bismaleimide resin (2) to obtain a prepreg (3), sticking a copper foil (4) onto one surface or both surfaces of the prepreg (3), and then subjecting said prepreg (3) and said copper foil (4) to a heat press under a high pressure,
the copper-clad laminate (12) characterized by providing an insulating layer (5) containing no glass fiber base (1) between said prepreg (3) and said copper foil (4).

2. In a copper-clad laminate formed by impregnating a glass fiber base (1) with epoxy resin (2), polyimide resin (2) or bismaleimide resin (2) to obtain a prepreg (3), sticking a copper foil (4) onto one surface or both surfaces of the prepreg (3), and then subjecting said prepreg (3) and said copper foil (4) to a heat press under a high pressure,
the copper-clad laminate (12) characterized by coating a resin between said prepreg (3) and said copper foil (4) and then carrying out a semi-curing treatment of by inserting a semi-cured resin film (7) between said prepreg (3) and said copper foil (4).

3. In a copper-clad laminate formed by impregnating a glass fiber base (1) with epoxy resin (2), polyimide resin (2) or bismaleimide resin (2) to obtain a prepreg (3), sticking a copper foil (4) onto one surface or both surfaces of the prepreg (3), and then subjecting said prepreg (3) and said copper foil (4) to a heat press under a high pressure,
the copper-clad laminate (12) characterized by coating an insulating binding agent (7) containing no glass fiber base (1) between said prepreg (3) and said copper foil (4).

4. In a process for producing a copper-clad laminate formed by impregnating a glass fiber base (1) with epoxy resin (2), polyimide resin (2) or bismaleimide resin (2) to obtain a prepreg (3), sticking a copper foil (4) onto one surface or both surfaces of the pregreg (3), and then subjecting said prepreg (3) and said copper foil (4) to a heat press under a high pressure,
the process for producing a copper-clad laminate (12) characterized by providing an insulating layer (5) on one surface or both surfaces of said prepreg (3), sticking a copper foil (4) onto the surface of said insulating layer (5), and thereafter carrying out a heat press under a high pressure.

5. In a process for producing a copper-clad laminate formed by impregnating a glass fiber base (1) with epoxy resin (2), polyimide resin (2) or bismaleimide resin (2) to obtain a prepreg (3), sticking a copper foil (4) onto one surface or both surfaces of the prepreg (3), and then subjecting said prepreg (3) and said copper foil (4) to a heat press under a high pressure,
the process for producing a copper-clad laminate (12) characterized by coating one surface or both surfaces of said prepreg (3) with a resin (2) and carrying out a semi-curing treatment or providing a semi-cured resin film (7), sticking a copper foil (4) onto the surface of the semi-cured resin coating on the prepreg (3) or the surface of the semi-cured resin film (7), and thereafter carrying out a heat press under a high pressure.

6. In a process for producing a copper-clad laminate formed by impregnating a glass fiber base (1) with epoxy resin (2), polyimide resin (2) or bismaleimide resin (2) to obtain a prepreg (3), sticking a copper foil (4) onto one surface or both surfaces of the prepreg (3), and then subjecting said prepreg (3) and said copper foil (4) to a heat press under a high pressure,
the process for producing a copper-clad laminate (12) characterized by coating one surface or both surfaces of the prepreg (3) with an insulating binding agent (7) containing no glass fiber base (1), sticking a copper foil (4) onto the insulating binding agent (7), and thereafter carrying out a heat press under a high pressure.

7. In a printed wiring board obtained by preparing a copper-clad laminate by impregnating a glass fiber base (1) with epoxy resin (2), polyimide resin (2) or bismaleimide resin (2) to form a prepreg (3), sticking a copper foil (4) onto one surface or both surfaces of the prepreg (3), carrying out a heat press under a high pressure, and then etching the copper foil (4) of the copper-clad laminate (12) so as to form a pattern having 0.1 mm or less space of conductive line (4a-d),
the printed wiring board characterized by providing an insulating layer (5) containing no glass fiber base (1) between the prepreg (3) and the copper foil (4).

8. In a printed wiring board obtained by preparing a copper-clad laminate by impregnating a glass fiber base (1) with epoxy resin (2), polyimide resin (2) or bismaleimide resin (2) to form a prepreg (3), sticking a copper foil (4) onto one surface or both surfaces of the prepreg (3), carrying out a heat press under a high pressure, and then etching the copper foil (4), of the copper-clad laminate (12) so as to form a pattern having 0.1 mm or less space of conductive line,
the printed wiring board characterized by coating a resin between said prepreg (3) and said copper foil (4) and carrying out a semi-curing treatment or by inserting a semi-cured resin film (7) between the prepreg (3) and the copper foil (4).

9. In a printed wiring board obtained by preparing a copper-clad laminate by impregnating a glass fiber base (1) with epoxy resin (2), polyimide resin (2) or bismaleimide resin (2) to form a prepreg (3), sticking a copper foil (4) onto one surface or both surfaces of the prepreg (3), carrying out a heat press under a high pressure, and then etching the copper foil (4) of the copper-clad laminate (12) so as to form a pattern having 0.1 mm or less space of conductive lines (4a-d),
the printed wiring board characterized by coating an insulating binding agent (7) containing no glass fiber base (1) between said prepreg (3) and said copper foil (4).

10. In a process for producing a printed wiring board by impregnating a glass fiber base (1) with epoxy resin (2), polyimide resin (2) or bismaleimide resin (2) to form a prepreg (3), sticking a copper foil (4) to one surface or both surfaces of the prepreg (3), carrying out a heat press under a high pressure to form a copper-clad laminate, and etching the copper foil (4) on the copper-clad laminate (12) so as to form a pattern having 0.1 mm or less space of conductive line (4a-d),
the process for producing a printed wiring board characterized by using a copper-clad laminate obtained by providing an insulating layer (5) containing no glass fiber base (1) on one surface or both surfaces of the prepreg (3), sticking a copper foil (4) onto the surface of the insulating layer (5) and thereafter carrying out a heat press under a high pressure.

11. In a process for producing a printed wiring board by impregnating a glass fiber base (1) with epoxy resin (2), polyimide resin (2) or bismaleimide resin (2) to form a prepreg (3), sticking a copper foil (4) to one surface or both surfaces of the prepreg (3), carrying out a heat press under a high pressure to form a copper-clad laminate, and etching the copper foil (4) on the copper-clad laminate (12) so as to form a pattern having 0.1 mm or less space of conductive line (4a-d),
the process for producing a printed wiring board characterized by using a copper-clad laminate (12) obtained by coating one surface or both surfaces of the prepreg (3) with a resin and carrying out a semi-curing treatment or inserting a semi-cured resin film (7), sticking a copper foil onto the surface of the semi-cured resin coating or the inserted semi-cured resin film (7), and thereafter carrying out a heat press under a high pressure.

12. In a process for producing a printed wiring board by impregnating a glass fiber base (1) with epoxy resin (2), polyimide resin (2) or bismaleimide resin (2) to form a prepreg (3), sticking a copper foil (4) to one surface or both surfaces of the prepreg (3), carrying out a heat press under a high pressure to form a copper-clad laminate, and etching the copper foil (4) on the copper-clad laminate (12) so as to form a pattern having 0.1 mm less space of conductive line (4a-d),
the process for producing a printed wiring board characterized by using a copper-clad laminate (12) obtained by coating one surface or both surfaces of the prepreg (3) with an insulating binding agent (7) containing no glass fiber base (1), sticking a copper foil (4) onto the insulating binding agent (7) and thereafter carrying out a heat press under a high pressure.
